# EUROPEAN PATENT SPECIFICATION

(11) **EP 0 406 949 B1**
(45) Date of publication and mention of the grant of the patent: **15.03.1995**
(21) Application number: 90201714.4
(22) Date of filing: 28.06.1990
(51) Int. Cl.: H03L 7/12, H04N 5/12

(54) **Oscillator circuit**
Oszillatorschaltung
Circuit oscillateur

(30) Priority: 04.07.1989 NL 8901698
(43) Date of publication of application: 09.01.1991
(73) Proprietor: Philips Electronics N.V., 5621 BA Eindhoven (NL)
(72) Inventor: Motté, Bruno Jean-Pierre, NL-5656 AA Eindhoven (NL)
(74) Representative: Steenbeek, Leonardus Johannes

(56) References cited:
- FR-A- 2 387 607
- GB-A- 1 116 263
- US-A- 4 634 939
- PATENT ABSTRACTS OF JAPAN, vol. 8, no. 84 (E-239)[1521], 18th April 1984;& JP-A-59 004 331 (FUJITSU K.K.) 11-01-1984

## Description

The invention relates to an oscillator arrangement as defined in the pre-characterizing part of Claim 1. The invention also relates to a synchronizing circuit and a picture display device.

Such an oscillator arrangement is known from FR-A-2,487,607 for use in a line synchronizing circuit of a television receiver. In this prior art circuit a main oscillator is frequency adjusted by a control signal from a control circuit in the form of a phase lock loop. The phase lock loop includes an auxiliary oscillator similar to the main oscillator; both comprise frequency determining capacitors integrated in the same semiconductor body. The phase lock loop synchronizes the auxiliary oscillator with a reference frequency clock signal by means of a control signal supplied to auxiliary oscillator. This control signal is the result of a phase comparison between the clock signal and a signal derived from said auxiliary oscillator. A proportional portion of the control signal is also fed to the main oscillator. This causes the main oscillator frequency to have a substantially fixed relation with the clock signal frequency. The clock signal is derived from a colour carrier oscillator in the television receiver; in many cases a crystal oscillator of high frequency accuracy. Accordingly, the main oscillator frequency becomes relatively well-defined, even if the accuracy of its frequency determining capacitance is rather poor. However, from the foregoing it will be obvious that the prior art arrangement is rather complicated.

The invention has, *inter alia*, for its object to provide an oscillator arrangement of the above-defined type which is of simpler structure than the prior art arrangement. To that end, a first and most basic aspect of the invention provides an oscillator arrangement as defined in Claim 1. A second aspect of the invention provides a synchronizing circuit as defined in Claim 5. A third aspect of the invention provides a picture display device as defined in Claim 6. Advantageous embodiments are defined in the dependent claims.

The oscillator arrangement according to the invention can be easily realized and comprises components which are not very critical. In a simple manner the oscillator arrangement can be dimensioned such that variations in response to spread and aging of the components and temperature variations between the components of the control circuit and of the oscillator are compensated for.

It is noted that GB-A-1,116,263 discloses a frequency discriminator for frequency-to-voltage conversion over an extended range. The frequency discriminator comprises a mixer-oscillator combination for frequency converting an input frequency to be demodulated. A circuit is coupled to the output of the mixer-oscillator combination for providing a first DC signal that is essentially an analog of the change in frequency between the input frequency and the oscillator frequency. The first DC signal is used to control the amplitude of a reference frequency, which is supplied to a rectifier-filter combination. Accordingly, a second DC signal analog of the difference between the input frequency and the oscillator frequency is obtained. This second DC signal is fed as control voltage to the oscillator.

Thus, GB-A-1,116,263 discloses a specific type of frequency demodulator, having a sort of Automatic Frequency Control (AFC) loop that relies on the presence of an input frequency, next to the reference frequency and the oscillator frequency. It will be understood that the structure and basic concepts of this demodulator, differ significantly from the oscillator arrangement according to the invention, which does not rely on the presence of an input frequency, but on the similarity between the frequency determining elements.

It is also noted that US-A-4,634,939 discloses an arrangement for adjusting the oscillator frequency in a phase lock loop, by means of adding a control signal to the phase locked loop. This control signal is obtained through frequency detection on a synchronizing signal on which the oscillator is to lock. Thus, the control signal is generated in a feedforward structure, rather than in a feedback structure which comprises a frequency determining element similar to that used in the oscillator, as in the invention.

It is further noted that JP-A-59,004,331 discloses an oscillator arrangement in which the output signal of an oscillator is fed to a control circuit. This control circuit provides a control signal as a result of a frequency-to-voltage conversion, for adjusting the frequency of the oscillator. No external reference frequency is used; the oscillator frequency accuracy will depend on the accuracy of control circuit components determining the frequency-to-voltage conversion characteristic. In contrast, the invention utilizes the accuracy of a clock signal frequency for generating a control signal to adjust the oscillator frequency to a pre-determined value.

This invention will now be described in greater detail by way of example with reference to the accompanying Figures. Therein:

Fig. 1 is a simplified basic circuit diagram of a circuit according to the invention.

Fig. 2 is a circuit diagram of a preferred embodiment of a control circuit which forms part of the circuit in accordance with the invention.

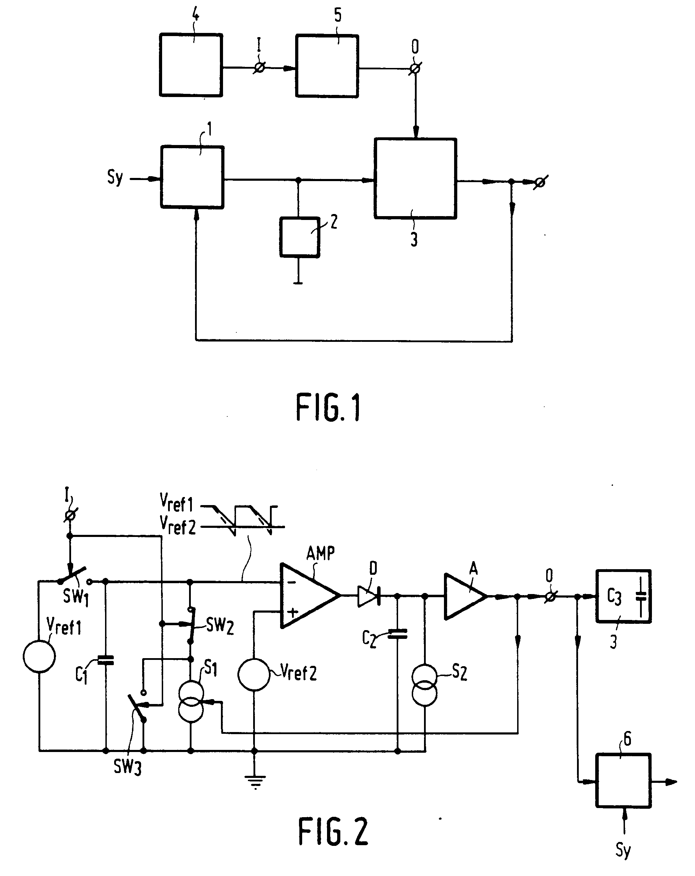

Fig. 1 shows a basic circuit diagram of a circuit according to the invention. At a first input a phase comparator stage 1 receives an incoming synchronizing signal Sy and at a second input a signal originating from an oscillator 3. Stages, not shown, for example a frequency divider can be present between the output of the oscillator 3 and the second input of the phase comparator stage when the oscillator frequency exceeds the frequency of the synchronizing signal. The phase comparator stage 1 supplies from an output a signal which depends on the phase difference between the input signal of stage 1 and which, after having been smoothed by a loop filter 2, is applied as the first control signal to the oscillator 3 for controlling the frequency and/or the phase of the oscillator signal. In the stable state of the phase control loop formed by elements 1, 2 and 3 the input signals of stage 1 have the same frequency at substantially the same phase.

A clock generator 4 generates a clock signal of a constant clock frequency and applies this clock signal to a control circuit 5. This control circuit 5 supplies a signal which is applied as the second control signal to the oscillator 3. The phase control loop generates the first control signal for the oscillator in the case the synchronizing signal is present. If the second control signal is now chosen appropriately, the oscillator frequency will be approximately halfway the lock-in rage, which is the nominal state.

Fig. 2 shows a more elaborate circuit diagram of the control circuit 5 of Fig. 1. At an input 1 the control circuit receives the clock signal from the clock generator 4 of Fig. 1. At an output O the control circuit generates an output signal which is applied as the second control signal to the oscillator 3 of Fig. 1. The present synchronizing circuit forms, for example, part of a picture display device, the oscillator 3 then being a line oscillator for the horizontal deflection having a nominal frequency of 15.75 kHz (United States televison standard). The oscillator 3 may have the line frequency or a multiple thereof. optionally, the local signal applied to the second input of stage 1 is supplied by a line deflection circuit, which circuit is supplied with a line signal originating from the oscillator. The clock signal is derived from a chrominance subcarrier signal having a nominal frequency of approximately 3.58 MHz. The clock generator 4 is, for example, a frequency divider receiving a signal originating from an auxiliary carrier oscillator and divides the frequency of this signal by 14, from which the clock signal can be obtained with a frequency of approximately 255 kHz.

The clock signal is a square-wave signal and drives controllable switches SW1, SW2 and SW3. The switch SW1 has one side connected to a first reference voltage source Vref1 and its other side to an inverting input of a differential amplifier AMP. In addition, a capacitor C1 and a controllable current source S1, are connected to this inverting input via a switch SW2. The capacitor and the current source S1 have their other side connected to ground. The junction point between the switch SW2 and the current source is connected to ground via the switch SW3. The non-inverting input of the differential amplifier AMP is connected to a second reference voltage source Vref2. The output of the amplifier AMP is connected to an input of an amplifier A via a rectifier D. A storage element constituted by a capacitor C2 which has its other end connected to ground is also connected to said input. The output of the amplifier A is fed back to a control input of the current source S1. The output of the amplifier A also constitutes the output O of the control circuit 5.

When the square-wave clock signal becomes high, the switches SW1 and SW3 become conductive and the switch SW2 is rendered non-conducting, and when the clock signal becomes low, the switches SW1 and SW3 are rendered non-conducting and the switch SW2 becomes conductive.

If the switch SW1 conducts, the first reference voltage Vref1 is present across the capacitor C1. The first reference voltage Vref1 exceeds the second reference voltage Vref2, as a result of which the amplifier AMP supplies a negative output voltage. Because of this negative voltage the rectifier D will not conduct. If the switches SW1 and SW3 become non-conducting, the voltage across the capacitor C1 decreases linearly because the switch SW2 is conducting and the current source S1 withdraws a constant current from the capacitor C1. When the voltage across C1 decreases to below the voltage Vref2, the amplifier AMP supplies a positive voltage and the rectifier D will conduct. A current which recharges the capacitor flows through the capacitor C2, in response to which the voltage across the capacitor and consequently the output voltage of the amplifier A increases. The current source S1 is controlled such that the current thereof obtains a lower voltage so that the sawtooth-shaped signal across the capacitor C1 reaches the value Vref2 at a later instant than would be the case when the current source S1 were not controlled. As a result thereof the current pulse through the rectifier D is of a shorter duration. This proves that in the stable state of the control loop formed by the elements C1, S1, AMP, D, C2 and A the edge of the sawtooth voltage produced during the time in which the switch SW1 is inhibited reaches the value Vref2 at the instant at which the switch becomes conductive again. At that instant the rectifier D is briefly conducting to compensate for discharging currents, illustrated in Fig. 2 by a current source S2. The sawtooth voltage across the capacitor C1, which has a constant frequency if the frequency of the clock signal of the generator 4 is constant, consequently has a substantially uniform slope as a fucntion of time (see Fig. 2), so that the value of the d.c. voltage at the output O only depends on the values of the elements of the circuit shown in Fig. 2. If these values are constant, then also said voltage is constant. The elements of the circuit can be chosen such that the said voltage is of such a value that the oscillator 3 supplies a signal having the nominal frequency.

It should be noted that the circuit of Fig. 2 can be structured differently to obtain the same result. The control for keeping the voltage across the capacitor C2 constant can alternatively be effected in response to an error signal which depends on the difference between this voltage and a third reference voltage. Thus it is achieved that in the foregoing tolerances of the circuit elements and changes caused by temperature fluctuations, aging and such like have not been taken into account. This can be explained in the following manner.

For the capacitor C1 which is discharged with the aid of a current source, it holds that the product of the current i1 of the source and the discharging time Δt is equal to the product of the capacitance C1 and the voltage difference ΔW1 = Vref1-Vref2 across the capacitor:$\text{i1*Δt = C1*ΔW1}$
The time Δt is a given portion of the clock signal period, for example half the period, so the clock frequency f = 1/(2*Δt). The equation (1) can be rewritten to:$\text{i1 = C1*ΔW1*2f}$

The oscillator 3 is of such a structure that the signal generated thereby has a uniform variation as a function of time of the same form as the signal at the inverting input of the amplifier AMP. The oscillator 3 consequently is a sawtooth generator having a different frequency than the generator with C1 and S1 and includes a capacitor C3 which is charged and discharged, respectively, between two reference voltage levels Vref1′ and Vref2′. For the respective charging and discharging current i2 of the capacitor C3 a value is chosen which is equal to k*i1, wherein, for example, k = 1. For the capacitor C3 a similar equation as for the capacitor C1 holds:$\text{i2*Δtosc = C3*ΔWosc}$
wherein
ΔWosc = Vref1′-Vref2′
and wherein Δtosc is the charging or discharging time of the capacitor C3. The equation (3) can be rewritten to$\text{Δtosc = C3*ΔWosc/i2}$
in this example i2 = i1; when this is filled up in equation (4) it results in:$\text{Δtosc = (C3*ΔWosc)/(C1*ΔW1*2f)} \text{= (C3/C1)*(ΔWosc/ΔW1)*(1/(2f))}$

The ratio C3/C1 is constant. If, in addition, the capacitors C1 and C3 are integrated in the same integrated circuit, then this ratio has a much narrower tolerance than the capacitances C1 and C3 themselves. The reference voltages Vref1 and Vref2 and the reference voltages Vref1′ and Vref2′ are chosen such that the ratios of ΔWosc/ΔW1, i.e. (Vref1-Vref2)/(Vref1′-Vref2′), is constant, independent of variations of the separate reference voltages. Since the frequency f of the clock generator is also constant, it follows that the time Δtosc and consequently the nominal frequency of the oscillator 3 is fully determined and is substantially independent of spreads in the components, temperature fluctuations or aging. It should be noted that the capacitance of the capacitor C2 is of no importance in the foregoing. The capacitor C2 must be chosen to have an adequately high value to attenuate the signal applied, but they must at the same time be small enough to prevent that they respond too slowly to permanent changes.

The control signal at the output O can alternatively be used in other portions of the picture display device, for example for a circuit for indicating the presence of a line or field synchronizing signal. Such a filter circuit is then used for signal identification purposes and in Figure 2 is denoted by reference numeral 6. If, for example, the line synchronizing signal Sy is applied to the circuit 6 in Fig. 2, then a signal having the line frequency is supplied. Spreads in this signal are compensated by the signal at the output O in a similar manner as the spreads in the signal originating from the oscillator 3.

## Claims

1. Oscillator arrangement (3,5) comprising an oscillator (3) having a frequency determining element (C3) and a control circuit (5) having a similar auxiliary frequency determining element (C1), an input (I) for receiving a clock signal and a control loop (S1, SW2, AMP, D, C2, A) responsive to a signal at said auxiliary frequency determining element (C1) and the clock signal, for adjusting the oscillation frequency of said oscillator (3) by means of a control signal in said control loop (S1, SW2, AMP, D, C2, A), characterized in that the control loop comprises a controllable DC source (S1) which is coupled to said auxiliary frequency determining element (C1) via a switch (SW2) responsive to said clock signal and means (AMP, D, C2, A) for controlling the controllable DC source in response to the magnitude of said signal at said auxiliary frequency determining element (C1).

2. Oscillator arrangement (3,5) as claimed in Claim 1, characterized in that the oscillator (3) is a relaxation oscillator in which said frequency determining element is a first capacitor (C3) coupled to a first current source for charging and discharging the first capacitor (C3), and in that the auxiliary frequency determining element (C1) is a second capacitor (C1), the controllable DC source being a second current source (S1).

3. Oscillator arrangement as claimed in Claim 2, characterized in that the first capacitor (C3) and the second capacitor (C1) are integrated in the same integrated circuit.

4. Oscillator arrangement as claimed in Claim 2 or 3, characterized in that arranged in parallel to said auxiliary frequency determining element (C1) there is a series arrangement of a first reference voltage source (Vref1) and an auxiliary switch (SW1) inversely responsive to said clock signal with respect to said switch (SW2), and in that said means comprises a rectifier circuit (AMP, D, C2) having a first input (-) which is coupled to said auxiliary frequency determining element (C1) and a second input (+) which is coupled to a second reference voltage source (Vref2).

5. Synchronizing circuit (1,2,3,5), characterized in that it comprises a phase detector (1), a loop filter (2) and an oscillator arrangement (3,5) as claimed in one of the preceding claims.

6. Picture display device, characterized in that it comprises an oscillator arrangement as claimed in one of the preceding claims and a clock generator (4) for supplying the clock signal to the input (I) of the control circuit (5).

7. Picture display device according to Claim 6, characterized in that the clock generator (4) comprises a frequency divider coupled to an auxiliary carrier oscillator.

8. Picture display device according to Claim 6 or 7, characterized in that the oscillator (3) is a line oscillator for the horizontal deflection.

9. Picture display device according to Claim 6, 7 or 8, characterized in that it comprises a signal identification circuit having an input for receiving said control signal from said control circuit (5).

## Patentansprüche

1. Oszillatorschaltung (3,5) mit einem Oszillator (3) mit einem frequenzbestimmenden Element (C3) und einer Steuerschaltung (5) mit einem ähnlichen hilfsfrequenzbestimmenden Element (C1), mit einem Eingang (I) zum Erhalten eines Taktsignal und mit einer Steuerschleife (S1, SW2, AMP, D, C2, A), die auf ein Signal an dem genannten hilfsfrequenzbestimmenden Element (C1) und auf das Taktsignal reagiert, zum Einstellen der Oszillatorfrequenz des genannten Oszillators (3) mittels eines Steuersignals in der genannten Regelschleife (S1, SW2, AMP, D, C2, A), dadurch gekennzeichnet, daß die Regelschleife eine regelbare DC-Quelle (S1) aufweist, die mit dem genannten hilfsfrequenzbestimmenden Element (C1) gekoppelt ist über einen Schalter (SW2), der auf das genannte Taktsignal reagiert und Mittel (AMP, D, C2, A) zur Regelung der regelbaren DC-Quelle in Antwort auf die Größe des genannten Signals an dem genannten hilfsfrequenzbestimmenden Element (C1).

2. Oszillatorschaltung (3,5) nach Anspruch 1, dadurch gekennzeichnet, daß der Oszillator (3) ein Relaxationsoszillator ist, in dem das genannte frequenzbestimmende Element ein erster Kondensator (C3) ist, der mit einer ersten Stromquelle gekoppelt ist zum Laden und Entladen des ersten Kondensators (C3), und daß das hilfsfrequenzbestimmende Element (C1) ein zweiter Kondensator (C1) ist, wobei die regelbare DC-Quelle eine zweite Stromquelle (S1) ist.

3. Oszillatorschaltung nach Anspruch 2, dadurch gekennzeichnet, daß der erste Kondensator (C3) und der zweite Kondensator (C1) in derselben integrierten Schaltung integriert sind.

4. Oszillatorschaltung nach Anspruch 2 oder 3, dadurch gekennzeichnet, daß parallel zu dem genannten hilfsfrequenzbestimmenden Element (C1) eine Reihenschaltung aus einer ersten Bezugsspannungsquelle (Vref1) und einem Hilfsschalter (SW1) vorgesehen ist, der gegenüber dem genannten Schalter (SW2) umgekehrt auf das genannte Taktsignal reagiert, und daß die genannten Mittel eine Gleichrichterschaltung (AMP, D, C2) aufweisen mit einem ersten Eingang (-), der mit dem hilfsfrequenzbestimmenden Element (C1) gekoppelt ist und einen zweiten Eingang (+), der mit einer zweiten Bezugsspannungsquelle (Vref2) gekoppelt ist.

5. Synchronschaltung (1,2,3,5), dadurch gekennzeichnet, daß diese Schaltungsanordnung einen Phasendetektor (1), ein Schleifenfilter (2) und eine Oszillatorschaltung (3,5) nach einem der vorstehenden Ansprüche aufweist.

6. Bildwiedergabeanordnung, dadurch gekennzeichnet, daß diese eine Oszillatorschaltung nach einem der vorstehenden Ansprüche aufweist und einen Taktgenerator (4) zum Liefern des Taktsignal zum Eingang (I) der Regelschaltung (5).

7. Bildwiedergabeanordnung nach Anspruch 6, dadurch gekennzeichnet, daß der Taktgenerator (4) einen mit einem Hilfsträgeroszillator gekoppelten Frequenzteiler aufweist.

8. Bildwiedergabeanordnung nach Anspruch 6 oder 7, dadurch gekennzeichnet, daß der Oszillator (3) ein Horizontal-Oszillator zur Horizontal-Ablenkung ist.

9. Bildwiedergabeanordnung nach Anspruch 6, 7 oder 8, dadurch gekennzeichnet, daß diese eine Signalerkennungsschaltung aufweist mit einem Eingang zum Erhalten des genannten Regelsignals von der genannten Regelschaltung (5).

## Revendications

1. Montage oscillateur (3, 5) comprenant un oscillateur (3) comportant un élément de détermination de fréquence (C3) et un circuit de commande (5) comportant un élément de détermination de fréquence auxiliaire similaire (C1), une entrée (I) pour recevoir un signal d'horloge et une boucle de commande (S1, SW2, AMP, D, C2, A) réagissant à un signal dans ledit élément de détermination de fréquence auxiliaire (C1) et au signal d'horloge, pour ajuster la fréquence d'oscillation dudit oscillateur (3) à l'aide d'un signal de commande dans ladite boucle de commande (S1, SW2, AMP, D, C2, A), caractérisé en ce que la boucle de commande comprend une source de courant continu pouvait être commandée (S1) qui est reliée audit élément de détermination de fréquence auxiliaire (C1) via un commutateur (SW2) réagissant audit signal d'horloge et des moyens (AMP, D, C2, A) pour commander la source de courant continu pouvant être commandée en réaction à l'amplitude dudit signal dans ledit élément de détermination de fréquence auxiliaire (C1).

2. Montage oscillateur (3, 5) selon la revendication 1, caractérisé en ce que l'oscillateur (3) est un oscillateur à relaxation dans lequel ledit élément de détermination de fréquence est un premier condensateur (C3) relié à une première source de courant pour charger et décharger le premier condensateur (C3), et en ce que ledit élément de détermination de fréquence auxiliaire (C1) est un deuxième condensateur (C1), la source de courant continu pouvant être commandée étant une deuxième source de courant (S1).

3. Montage oscillateur selon la revendication 2, caractérisé en ce que le premier condensateur (C3) et le deuxième condensateur (C1) sont intégrés dans le même circuit intégré.

4. Montage oscillateur selon la revendication 2 ou 3, caractérisé en ce qu'en parallèle avec ledit élément de détermination de fréquence auxiliaire (C1) est agencé un montage en série d'une première source de tension de référence (Vref1) et d'un commutateur auxiliaire (SW1) inversement sensible audit signal d'horloge par rapport audit commutateur (SW2), et en ce que lesdits moyens comprennent un circuit redresseur (AMP, D, C2) ayant une première entrée (-) qui est reliée audit élément de détermination de fréquence auxiliaire (C2) et une deuxième entrée (+) qui est reliée à une deuxième source de tension de référence (Vref2).

5. Circuit de synchronisation (1, 2, 3, 5), caractérisé en ce qu'il comprend un détecteur de phase (1), un filtre de boucle (2) et un montage oscillateur (3, 5) selon l'une quelconque des revendications précédentes.

6. Dispositif d'affichage d'image, caractérisé en ce qu'il comprend un circuit oscillateur selon l'une quelconque des revendications précédentes et un générateur de signaux d'horloge (4) pour fournir un signal d'horloge à l'entrée (I) du circuit de commande (5).

7. Dispositif d'affichage d'image selon la revendication 6, caractérisé en ce que le générateur de signaux d'horloge (4) comprend un diviseur de fréquence relié à un oscillateur à fréquence porteuse auxiliaire.

8. Dispositif d'affichage d'image selon la revendication 6 ou 7, caractérisé en ce que l'oscillateur (3) est un oscillateur de ligne pour la déviation horizontale.

9. Dispositif d'affichage d'image, selon la revendication 6, 7 ou 8, caractérisé en ce qu'il comprend un circuit d'identification de signal ayant une entrée pour recevoir ledit signal de commande dudit circuit de commande (5).
